**Europäisches Patentamt**

**European Patent Office**

**Office européen des brevets**

(19)

(11) Veröffentlichungsnummer: **0 033 154**

**A2**

(12) # EUROPÄISCHE PATENTANMELDUNG

(21) Anmeldenummer: **81100554.5**

(22) Anmeldetag: **26.01.81**

(51) Int. Cl.³: **G 05 F 3/20**
**H 01 L 27/02**

(30) Priorität: **28.01.80 DE 3002894**

(43) Veröffentlichungstag der Anmeldung:
**05.08.81 Patentblatt 81/31**

(84) Benannte Vertragsstaaten:
**FR GB**

(71) Anmelder: **SIEMENS AKTIENGESELLSCHAFT Berlin und München**
**Postfach 22 02 61**
**D-8000 München 22(DE)**

(72) Erfinder: **Hoffmann, Kurt, Dr.**
**Nelkenweg 20**
**D-8028 Taufkirchen(DE)**

(54) **Monolithisch integrierte Halbleiterschaltung mit Transistoren.**

(57) Die Erfindung bezieht sich auf eine Methode zur Erzeugung der Substratvorspannung für eine monolithisch intergrierte Halbleiterschaltung. Bei üblichen Schaltungen dieser Art ist das die Schaltung aufnehmende Halbleiterplättchen mit zwei an je ein Versorgungspotential zu legenden externen Anschlüssen versehen. Außerdem ist in der Schaltung ein sog. Substratvorspannungsgenerator zur Erzeugung einer Gleichspannung vorgesehen, die zwischen dem die einzelnen Elemente der integrierten Schaltung aufnehmenden Substratbereich des Halbleiterplättchen und z. B. einen für das Bezugsbetriebspotential zuständigen Schaltungspunkt der eigentlichen integrierten Halbleiterschaltung liegt. Der Substratvotspannungsgenerator wird bei den üblichen integrierten Halbleiterschaltungen unmittelbar von den beiden externen Versorgungsanschlüssen beaufschlagt. Um nun eine Möglichkeit zu schaffen, die Betriebsspannung zwischen den beiden Versorgungsanschlüssen zu reduzieren, ist gemäß der Erfindung vorgesehen, daß die an den beiden Versorgungsanschlüssen des Halbleiterplättchens anleigende Spannung durch die Serienschaltung des Substrationsvorspannungserzeugers und der integrierten Schaltung so geteilt ist, daß das erforderliche Bezugsbetriebspotential für die eigentliche integrierte Schaltung entsteht.

FIG 3

SIEMENS AKTIENGESELLSCHAFT      Unser Zeichen
Berlin und München             VPA  80 P 1 0 1 2 E

Monolithisch integrierte Halbleiterschaltung mit Transistoren

Die Erfindung bezieht sich auf eine monolithisch integrierte Halbleiterschaltung mit Transistoren, insbesondere mit MOS-Feldeffekttransistoren, bei der die Elemente der eigentlichen Halbleiterschaltung an der Vorderseite eines insbesondere aus monokristallinem Silicium bestehenden Halbleiterplättchens erzeugt sind, bei der außerdem zwei durch je ein Betriebspotential zu beaufschlagende Versorgungsanschlüsse an der Oberfläche des Halbleiterplättchens vorgesehen sind, die einerseits mit den Elementen der eigentlichen Halbleiterschaltung und andererseits mit einem zusätzlichen Schaltungsteil verbunden sind, mit dessen Hilfe eine Substratvorspannung erzeugt ist, die an den die Rückseite des Halbleiterplättchens einnehmenden Substratbereich und wenigstens an einen der eigentlichen Halbleiterschaltung angehörenden Halbleiterbereich beziehungsweise einer den Halbleiterbereich steuernden und gegen diesen isolierten Gateelektrode an der Vorderseite des Halbleiterplättchens gelegt ist.

Schaltungen dieser Art sind allgemein bekannt und werden vor allem bei digitalen Halbleiterschaltungen, zum Beispiel bei Halbleiterspeichern, angewendet. Ein Beispiel für eine solche Schaltung ist in "1979 IEEE International Solid-State Circuits Conference", Seiten 142, 143 dargestellt.

Stg 1 Dx / 25.01.1980

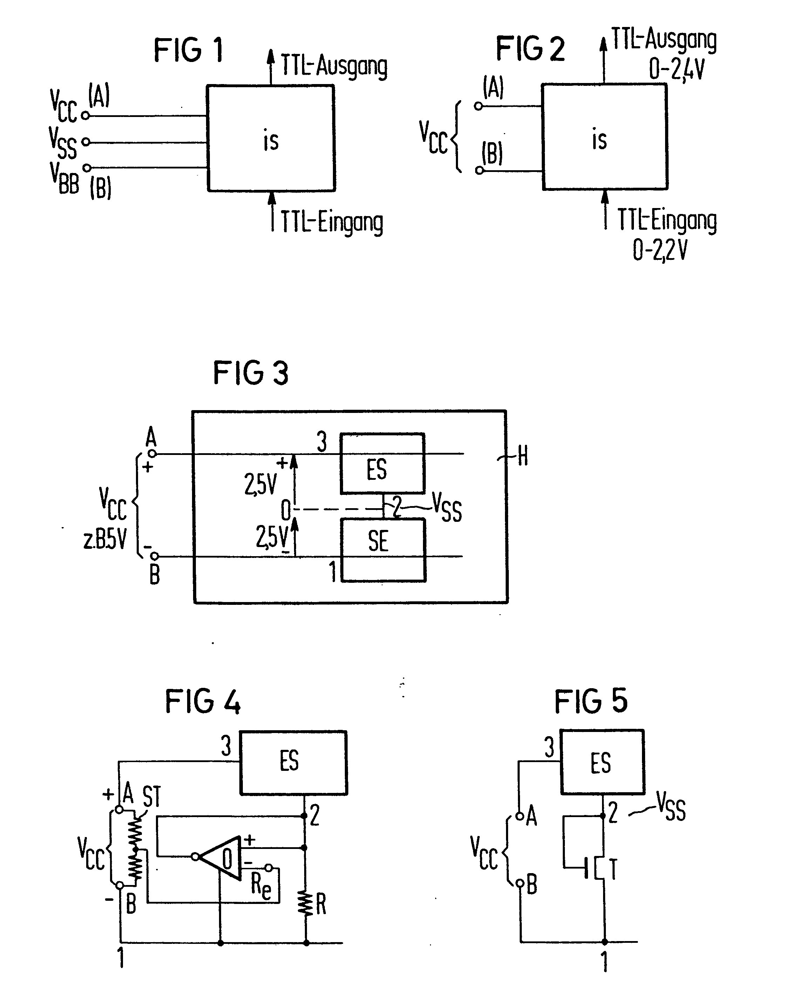

Allgemein sind nun bei der Herstellung von monolithisch integrierten Halbleiterschaltungen folgender Gesichtspunkt von Bedeutung, nämlich der Trend zu niedrigeren Versorgungsspannungen. So benötigt man bei einer in n-Kanal-MOS-Technik ausgeführten monolithisch integrierten Halbleiterschaltung ein - gewöhnlich zugleich das Bezugspotential darstellendes - gemeinsames Sourcepotential $V_{SS}$ und ein Drainpotential $V_{CC}$ von +5 V gegenüber dem Bezugspotential $V_{SS}$. Außerdem braucht man für die Rückseite des Halbleiterplättchens eine auf das Bezugspotential bezogene Substratvorspannung von -5 V. Im einzelnen sind die erforderlichen Potentiale in Fig. 1 dargestellt, die in der integrierten Halbleiterschaltung IS benötigt werden.

Es ist nun Aufgabe der Erfindung, eine Möglichkeit anzugeben, mit deren Hilfe man die an die beiden Versorgungsanschlüsse des Halbleiterplättchens zu legende Betriebsspannung gegenüber den aus Fig. 1 ersichtlichen Werten, nämlich von etwa 10 V, auf die aus Fig. 2 ersichtlichen Verhältnisse reduzieren kann. Die in Klammer bei Fig. 1 und 2 angegebenen Buchstaben A und B bezeichnen die beiden Versorgungsklemmen des die integrierte Schaltung IS darstellenden Halbleiterplättchens.

Zur Lösung dieser Aufgabe ist nun erfindungsgemäß vorgesehen, das $V_{SS}$-Potential (Bezugspotential) in dem IC zu erzeugen. Die an den beiden Versorgungsanschlüssen des Halbleiterplättchens anliegende Spannung wird durch die Serienschaltung des Substratvorspannungserzeugers und der integrierten Schaltung so geteilt, daß ein $V_{SS}$-Potential auf dem IC entsteht.

Damit ergibt sich das aus Fig. 3 ersichtliche Schaltungsprinzip: Die beiden Versorgungsanschlüsse A und B des Halbleiterplättchens H, das wohl in den meisten Fällen aus einkristallinem Silicium (gegebenenfalls auch aus einkristallinem GaAs) besteht, sind über die Serienschaltung der eigentlichen integrierten Halbleiterschaltung ES und eines zusätzlichen Schaltungsteils SE zur Erzeugung der Substratvorspannung überbrückt. Insbesondere ist dabei vorgesehen, daß keine weiteren Verbindungen zwischen den beiden Anschlüssen A und B und der eigentlichen integrierten Halbleiterschaltung ES beziehungsweise dem Substratvorspannungserzeuger existieren.

Die verschiedenen Möglichkeiten der Erfindung werden nun an Hand der Fig. 3 bis 8 näher erläutert:

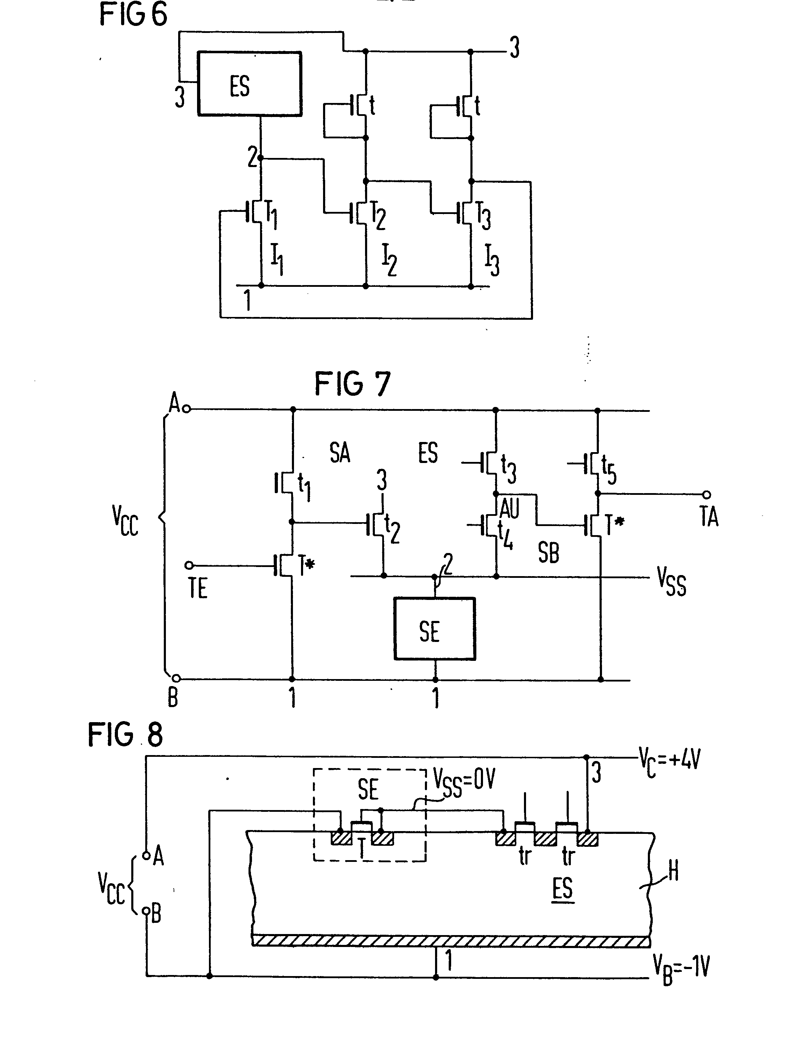

In Fig. 4 ist das Prinzipschaltbild für einen Substratvorspannungserzeuger SE, in Fig. 5 eine besonders einfache Ausgestaltung desselben und in Fig. 6 eine erweiterte Ausgestaltung dargestellt. Fig. 7 bezieht sich auf die Ausgestaltung zusätzlicher Schaltungsteile, die benötigt werden, wenn die eigentliche integrierte Schaltung nicht nur MOS-Feldeffekttransistoren, sondern auch bipolare Transistoren enthält, also wenn es sich um MOS-TTL-Kombinationen handelt.

Das in Fig. 4 dargestellte Prinzipschaltbild für einen Substratvorspannungserzeuger SE enthält als wesentlichen Bestandteil einen invertierenden Operationsverstärker O, dessen nichtinvertierender Eingang + einerseits über einen Widerstand R mit dem das eine Betriebspotential führenden Versorgungsanschluß B verbunden ist und andererseits an den das Bezugspotential, zum Beispiel $V_{SS}$, für die eigentliche integrierte Halbleiterschaltung ES führenden internen Versorgungsanschluß 2 derselben angelegt ist. Weiterhin ist für den Operationsverstärker O eine Gegenkopplung vorgesehen, indem dessen Ausgang an den nichtinvertierenden Eingang + und damit an den Schaltungsknoten 2 zwischen dem Widerstand R und der eigentlichen integrierten Schaltung, also mit anderen Worten, an dessen das Bezugspotential erhaltenden internen Anschluß 2 gelegt ist.

Der invertierende Eingang des Operationsverstärkers O liegt an einem Referenzpotential Re von 0 V, das zum Beispiel mittels eines Spannungsteilers ST aus der an den beiden Versorgungsanschlüssen A, B angelegten Betriebsspannung $V_{CC}$ abgeleitet werden kann. Da die beiden, den Spannungsteiler ST bildenden - zum Beispiel gleichgroßen - Teilwiderstände hochohmig ausgestaltet werden können, läßt sich der Stromverlust gering gestalten, so daß der Spannungsteiler ST gegebenenfalls auch mitintegriert werden kann.

Der das zweite Betriebspotential führende interne Anschluß 3 der eigentlichen integrierten Halbleiterschaltung ES ist unmittelbar an den anderen Versorgungsanschluß A des Halbleiterplättchens H gelegt. Ob der Anschluß A des Halbleiterplättchens H an die positive oder an die negative Klemme der die Versorgungspotentiale liefernden Gleichspannungsquelle zu legen ist, hängt von der Art der in der Schaltung verwendeten Transistoren ab. Sind die Transistoren als MOS-Feldeffekttransistoren vom n-Kanaltyp ausgebildet, so liegt am Anschluß A die positive Versorgungsklemme und am Anschluß B die negative Klemme der Gleichspannungsquelle. Die zwischen den Anschlüssen A und B liegende Versorgungsspannung $V_{CC}$ braucht dann nicht höher als zum Beispiel 5 V zu sein.

Der mit "1" bezeichnete Substratanschluß ist unmittelbar mit dem Versorgungsanschluß B des Halbleiterkörpers H verbunden beziehungsweise mit diesem identisch. Er liegt, wie aus Fig. 4 ersichtlich, nicht nur an dem einen Ende des Widerstands R, sondern führt auch das Bezugspotential für den invertierenden Operationsverstärker O, des-

sen zweites Betriebspotential $V_{CC}$ über den Knoten 2 vom Versorgungsanschluß A über den internen Versorgungseingang 3 der eigentlichen integrierten Schaltung ES geliefert wird.

Ersichtlich ist auf Grund der in Fig. 4 gezeigten Schaltung eine Regelung des am internen Versorgungseingang 2 der eigentlichen integrierten Schaltung ES liegenden Bezugspotentials $V_{SS}$ gegeben.

Die Realisierung des durch die Kombination aus Operationsverstärker O und dem Widerstand R gegebenen Schaltungsteils SE zur Erzeugung der Substratvorspannung läßt sich in der aus Fig. 5 ersichtlichen Weise besonders einfach nur durch einen einzigen MOS-Feldeffekttransistor T vom Anreicherungstyp oder auch vom Verarmungstyp darstellen, wobei der Kanaltyp dieses Transistors T der Kanaltyp der übrigen Feldeffekttransistoren der integrierten Halbleiterschaltung ist, der zunächst als einheitlich vorausgesetzt wird. Ist also die Schaltung aus n-Kanal-Feldeffekttransistoren aufgebaut, so ist auch der Transistor T ein Feldeffekttransistor vom n-Kanaltyp.

In allen Fällen liegt dann die Source-Drainstrecke des Feldeffekttransistors T zwischen dem das Potential führenden Anschluß B des Halbleiterkörpers H (also insbesondere zwischen dem Substratanschluß 1) und dem internen Anschluß 2 der eigentlichen Halbleiterschaltung ES mit dem Bezugspotential $V_{SS}$. Außerdem ist der Drainanschluß des Transistors T unmittelbar mit dem Gate dieses Transistors T verbunden und damit ebenfalls an das zu erzeugende Bezugspotential $V_{SS}$ der eigentlichen Halbleiterschaltung ES gelegt. Der Widerstand R ist bei der aus Fig. 5 ersichtlichen Schaltung implizit durch die Source-Drainstrecke des Transistors T gegeben, ebenso wie das angestrebte Regelverhalten, also die wesentliche
Wirkung des Operationsverstärkers O gemäß der Ausgestaltung nach Fig. 4, durch die aus Fig. 5 ersichtliche Ausgestaltung ohne weitere Schaltungsmaßnahmen realisiert
ist.

Der wesentliche Vorteil der in Fig. 5 dargestellten Ausbildung des Substratvorspannungserzeugers ist darin zu
sehen, daß ein Referenzpotential Re nicht erforderlich
ist und somit - im Gegensatz zur Ausgestaltung gemäß
Fig. 4 - eine zusätzliche Verbindung zwischen den Versorgungsanschlüssen A und B des Halbleiterplättchens H
und dem die geregelte Substratvorspannung, also das Bezugspotential $V_{CC}$ der eigentlichen Schaltung ES liefernden Schaltungsteil SE entfällt.

Dasselbe gilt für eine Ausgestaltung des die Substratvorspannung liefernden Schaltungsteils ES gemäß Fig. 6.
Hier ist anstelle eines Transistors T eine aus mehreren
Transistoren bestehende Verstärkerkaskade vorgesehen.
Diese besteht in dem dargestellten Beispielsfall aus
drei Invertern, wobei der Ausgang des letzten Inverters
auf den Eingang des ersten Inverters rückgekoppelt ist,
um die für die Lieferung eines geregelten Bezugspotentials $V_{SS}$ am internen Versorgungseingang 2 der eigentlichen Schaltung ES erforderliche Gegenkopplung zu sichern.

Zu bemerken ist, daß bei der in Fig. 6 dargestellten
Schaltung - im Gegensatz zu der Ausgestaltung nach
Fig. 5 - wiederum eine nicht über die eigentliche Halbleiterschaltung ES geführte Verbindung zwischen den beiden Anschlüssen A und B des Halbleiterplättchens H zusätzlich vorgesehen ist, da jede der nachgeschalteten
Inverterstufen der Verstärkerkaskade unmittelbar durch
die an den beiden Versorgungsanschlüssen A und B anhängigen Versorgungspotentiale geschaltet ist.

Die erste Verstärkerkaskade bei der aus Fig. 6 ersichtlichen Ausgestaltung ist durch einen Treibertransistor $T_1$ in Serie mit einem durch die Gesamtheit der Strompfade in der eigentlichen integrierten Halbleiterschaltung ES gebildeten Lastwiderstand gegeben, über den der Drain des Transistors $T_1$ am Versorgungsanschluß 3 der eigentlichen Schaltung ES und damit am Versorgungsanschluß A angeschlossen ist. Der Sourceanschluß des Treibertransistors $T_1$ der ersten Inverterstufe $I_1$ liegt am Anschluß 1 des Substrats und damit am Versorgungsanschluß B.

Die übrigen Verstärkerkaskaden (in Fig. 3 sind die drei Verstärkerkaskaden $I_2$ und $I_3$ noch vorgesehen) bestehen jeweils aus einem Treibertransistor $T_2$ beziehungsweise $T_3$ und so weiter, der in Serie mit je einem als Widerstand geschalteten Transistor t, zum Beispiel Depletion Transistor (Verarmungs Type), liegt, wobei der Sourceanschluß des Treibertransistors unmittelbar mit dem Anschluß 1, der Drainanschluß des Treibertransistors mit dem Sourceanschluß des jeweiligen als Lastwiderstand t geschalteten Transistors sowie mit dessen Gate unmittelbar verbunden ist. Die Drainanschlüsse der Lastwiderstände t der zweiten und der folgenden Inverterstufe $I_2$, $I_3$ und so weiter liegen sämtlich gemeinsam mit dem internen Anschluß 3 für das andere Versorgungspotential $V_{CC}$ der eigentlichen integrierten Halbleiterschaltung ES an dem dieses Versorgungspotential liefernden Anschluß A des Halbleiterplättchens H.

Die Ausgänge der einzelnen Inverterstufen $I_1$, $I_2$, $I_3$ und so weiter sind durch die Drainanschlüsse ihrer Treibertransistoren $T_1$, $T_2$, $T_3$ und so weiter gegeben, während ihre Signaleingänge durch die Gateelektroden ihrer Treibertransistoren gebildet sind. Um die Verstärkerkaskade zu bilden, ist der Ausgang der ersten Inverterstufe $I_1$ an den Eingang der zweiten Inverterstufe, der Aus-

gang der zweiten Inverterstufe $I_2$ an den Eingang der dritten Inverterstufe $I_3$ und so weiter gelegt. Der Ausgang der die letzte Kaskade bildenden Inverterstufe - im Beispiel der Schaltung gemäß Fig. 6 der Inverterstufe $I_3$ - ist an den Eingang der ersten Inverterstufe, also der ersten Kaskadenstufe (das heißt an das Gate des Transistors $T_1$) gelegt.

Gegenüber einer Schaltung gemäß Fig. 5 ist die höhere Regelempfindlichkeit als Vorteil und der höhere Schaltungsaufwand als Nachteil zu verzeichnen. Die Transistoren $T_1$, $T_2$, $T_3$, t sind vom Typ der übrigen Transistoren der Schaltung. Handelt es sich um integrierte Halbleiterschaltungen ES, die neben Feldeffekttransistoren noch bipolare Transistoren enthalten, so können die an Hand der Fig. 4 bis 6 beschriebenen Ausgestaltungen des für die Erzeugung der Substratvorspannung und damit des Bezugspotentials $V_{SS}$ für die eigentliche integrierte Halbleiterschaltung dienenden zusätzlichen Schaltungsteils SE unmittelbar übernommen werden. Handelt es sich dabei um eine TTL-gesteuerte beziehungsweise einen TTL-Schaltungsteil steuernde integrierte Schaltung ES, so muß der Schaltungsteil SE zusätzlich zu der aus den Fig. 4 bis 6 ersichtlichen Weise in der aus Fig. 7 ersichtlichen Weise ergänzt werden.

Wesentlich für diese Ergänzung ist jeweils ein Feldeffekt-MOS-Transistor $T^*$ vom Anreicherungstyp und vom selben Kanaltyp wie die übrigen Transistoren der integrierten Halbleiterschaltung, dessen Dotierung durch Ionenimplantation so eingestellt ist, daß seine Einsatzspannung an den den MOS-Schaltungsteil steuernden TTL-Eingang beziehungsweise an den durch den MOS-Schaltungsteil gesteuerten MOS-Schaltungsteil angepaßt ist. Der für eine TTL-Signalsteuerung vorzusehende zusätzliche Schaltungsteil SA ist der linken Hälfte und der für die Beaufschlagung eines TTL-Schaltungsteils vorzusehende zusätzliche Schaltungsteil SB ist der rechten Hälfte der
Fig. 7 entnehmbar.

Der TTL-Schaltungsteil kann extern zu dem die integrierte Halbleiterschaltung aufnehmenden Halbleiterplättchen,
zum Beispiel in Form eines zweiten IC-Bausteins, vorgesehen sein. Er kann aber auch monolithisch mit der Halbleiterschaltung einschließlich des Schaltungsteils SE
vereinigt sein. Dient der TTL-Schaltungsteil zur Steuerung des MOS-Schaltungsteils ES, so weist dieser einen
durch die vom TTL-Schaltungsteil abgegebenen Signale gesteuerten TTL-Eingang TE auf. Dient der MOS-Schaltungsteil zur Steuerung des TTL-Schaltungsteils, so hat der
MOS-Schaltungsteil einen TTL-Ausgang TA, der dann an den
Steuereingang des zu steuernden TTL-Schaltungsteils zu
legen ist.

Der durch einen TTL-Schaltungsteil zu steuernde Eingang
TE der einen Bestandteil der eigentlichen integrierten
Halbleiterschaltung bildenden MOS-Schaltung ES ist über
den Anpassungstransistor $T^*$ an den durch den MOS-Transistor $t_2$ gegebenen Eingang der MOS-Schaltung ES gelegt.
Hierzu ist der Anpassungstransistor $T^*$ mit seinem Gate
an den TTL-Eingang (also an den Ausgang des steuernden
TTL-Schaltungsteils) TE gelegt, während sein Sourceanschluß am Substratanschluß 1 und damit am Versorgungsanschluß B liegt. Der Drain des Anpassungstransistors $T^*$
ist einerseits über eine zum Beispiel durch einen Transistor $t_1$ gegebene Last an den anderen Versorgungsanschluß A und außerdem an das Gate des den Signaleingang
der eigentlichen MOS-Halbleiterschaltung ES bildenden
Eingangstransistors $t_2$ gelegt. Das Bezugspotential $V_{SS}$
für die eigentliche MOS-Halbleiterschaltung ES, also
auch für den Eingangstransistor $t_2$ das Sourcepotential,

wird durch den Ausgang 2 des Substratvorspannungserzeugers SE geliefert.

Für den Fall, daß der MOS-Teil der eigentlichen Halbleiterschaltung zur Steuerung eines internen oder externen TTL-Schaltungsteils vorgesehen ist, dient der ebenfalls aus Fig. 7 ersichtliche Schaltungsteil SB. Hier ist der zum Beispiel durch die Serienschaltung der Source-Drainstrecken zweier Feldeffekttransistoren $t_3$, $t_4$ gebildete und durch einen Schaltungspunkt zwischen diesen beiden Transistoren gegebene Ausgang AV des MOS-Schaltungsteils ES an das Gate des Anpassungstransistors $T^*$ gelegt, dessen Drain den an den Eingang eines TTL-Schaltungsteils zu legenden TTL-Ausgang TA bildet und über eine - zum Beispiel durch einen weiteren Transistor $t_5$ gegebene - Last an den das Versorgungspotential $V_{CC}$ für die MOS-Schaltung ES liefernden Versorgungsanschluß A gelegt ist, während sein Sourceanschluß mit dem Anschluß 1 und damit mit dem Anschluß B für die Spannungsversorgung der Gesamtschaltung unmittelbar verbunden ist. Die Anschaltung des das Bezugspotential $V_{SS}$ für den der eigentlichen integrierten Halbleiterschaltung ES angehörenden MOS-Schaltungsteils entspricht der Anschaltung gemäß den Fig. 4, 5 und 6.

Die technologische Ausgestaltung der in Fig. 5 dargestellten Ausführung einer Halbleiterschaltung gemäß der Erfindung kann im einfachsten Fall entsprechend Fig. 8 ausgeführt sein. An der Vorderseite des zum Beispiel n-dotierten Halbleiterplättchens H sind unter anderem der n-Kanal-Transistor T und mehrere der eigentlichen integrierten Schaltung ES angehörende n-Kanal-Transistoren tr vorgesehen. In Fig. 8 sind zwei dieser Transistoren tr eingezeichnet, die zum Beispiel zusammen eine Inverterstufe bilden, die einerseits vom Ausgang des die Bezugsspannung $V_{SS}$ liefernden Schaltungsteils SE, ande-

0033154

rerseits durch den mit dem Potential $V_{CC}$ zu beaufschlagenden internen Versorgungsanschluß 3 mit der hierzu erforderlichen Versorgungsspannung betrieben sind.

Zu bemerken ist, daß bei allen diesen Ausführungsbeispielen eine Versorgungsspannung $V_{SS}$ von 5 V für die Versorgungsanschlüsse AB genügt, wenn die Transistoren in n-Kanal-Technik realisiert sind. Bestehen die Transistoren aus p-Kanal-Feldeffekttransistoren, so wird eine Versorgungsspannung $V_{CC}$ von zum Beispiel -5 V benötigt, wobei der Anschluß B an die positive Klemme und der Anschluß A an die negative Klemme der die Versorgungsspannung $V_{CC}$ liefernden Gleichspannungsquelle zu legen ist.

8 Figuren
9 Patentansprüche

Patentansprüche

1. Monolithisch integrierte Halbleiterschaltung mit Transistoren, insbesondere mit MOS-Feldeffekttransistoren, bei der die Elemente der eigentlichen Halbleiterschaltung an der Vorderseite eines insbesondere aus monokristallinem Silicium bestehenden Halbleiterplättchens erzeugt sind, bei der außerdem zwei durch je ein Betriebspotential zu beaufschlagende Versorgungsanschlüsse an der Oberfläche des Halbleiterplättchens vorgesehen sind, die einerseits mit den Elementen der eigentlichen Halbleiterschaltung und andererseits mit einem zusätzlichen Schaltungsteil verbunden sind, mit dessen Hilfe eine Substratvorspannung erzeugt ist, die an den die Rückseite des Halbleiterplättchens einnehmenden Substratbereich und wenigstens an einen der eigentlichen Halbleiterschaltung angehörenden Halbleiterbereich beziehungsweise einer den Halbleiterbereich steuernden und gegen diesen isolierten Gateelektrode an der Vorderseite des Halbleiterplättchens gelegt ist, d a d u r c h g e k e n n z e i c h n e t , daß die an den beiden Versorgungsanschlüssen (A, B) des Halbleiterplättchens (H) anliegende Spannung durch die Serienschaltung des Substratvorspannungserzeugers (SE) und der integrierten Schaltung (ES) so geteilt ist, daß das erforderliche Bezugspotential ($V_{SS}$) für die integrierte Schaltung (ES) entsteht.

2. Halbleiterschaltung nach Anspruch 1, d a d u r c h g e k e n n z e i c h n e t , daß der Substratvorspannungserzeuger (SE) und die mit ihm in Serie bezüglich der Versorgungsanschlüsse (A, B) des Halbleiterplättchens (H) liegende eigentliche Halbleiterschaltung (ES) aus MOS-Feldeffekttransistoren vom gleichen Kanaltyp, insbesondere vom n-Kanaltyp aufgebaut ist.

3. Halbleiterschaltung nach Anspruch 1 oder 2, d a - d u r c h  g e k e n n z e i c h n e t , daß der das zur Beaufschlagung des von dem Bezugspotential ($V_{SS}$) verschiedenen Betriebspotentials ($V_{CC}$) dienende interne Anschluß (3) der eigentlichen integrierten Schaltung (ES) unmittelbar mit dem einen Versorgungsanschluß (A) des Halbleiterplättchens (H) und der das andere Bezugspotential (-) für den Substratvorspannungserzeuger (SE) führende Versorgungseingang und mit dem Substratanschluß (1) identische Anschluß des Substratvorspannungserzeugers (SE) unmittelbar mit dem anderen Versorgungseingang (B) des Halbleiterplättchens (H) verbunden, insbesondere mit diesem identisch ist.

4. Halbleiterschaltung nach den Ansprüchen 1 bis 3, d a d u r c h  g e k e n n z e i c h n e t , daß der Substratvorspannungserzeuger (SE) aus einem gegengekop- pelten Operationsverstärker (O) mit invertierendem Aus- gang und einem nichtinvertierenden und einem invertierenden Ausgang besteht, daß dabei der Ausgang des inver- tierenden Operationsverstärkers (O) unmittelbar mit dem nichtinvertierenden Eingang (+) sowie mit dem durch das Bezugspotential ($V_{SS}$) für die eigentliche Halbleiterschaltung (ES) führenden internen Versorgungseingang (2) derselben verbunden ist, daß außerdem dieser interne Versorgungseingang über einen Widerstand (R) an den zugleich das Bezugspotential für den Operationsverstärker (O) führenden Substratanschluß (1) gelegt ist.

5. Halbleiterschaltung nach Anspruch 4, d a d u r c h g e k e n n z e i c h n e t , daß der invertierende Eingang (-) des Operationsverstärkers (O) an ein mittels eines Spannungsteilers (ST) aus den beiden an den Versorgungsanschlüssen (A, B) des Halbleiterplättchens (H) anhängigen Versorgungspotential abzuleitendes Nullpotential (Re) gelegt ist.

6. Halbleiterschaltung nach den Ansprüchen 2 und 3, d a d u r c h   g e k e n n z e i c h n e t , daß der Substratvorspannungserzeuger (SE) durch einen Feldeffekttransistor (T) vom Anreicherungstyp und vom Kanaltyp der die eigentliche Halbleiterschaltung (ES) aufbauenden Feldeffekttransistoren gegeben ist, dessen Source an den Substratanschluß (1) und dessen Gate und Drain an den das Bezugspotential ($V_{SS}$) für die eigentliche Halbleiterschaltung (ES) führenden internen Anschluß (2) dieser eigentlichen Halbleiterschaltung (ES) gelegt sind.

7. Halbleiterschaltung nach den Ansprüchen 2 und 3, d a d u r c h   g e k e n n z e i c h n e t , daß der Substratvorspannungserzeuger (SE) durch einen aus mehreren Kaskaden ($I_1$, $I_2$, $I_3$) bestehenden Verstärker gebildet ist, daß dabei die aus der Serienschaltung eines Feldeffekttransistors ($T_1$) mit den Stromversorgungsbahnen der aus Feldeffekttransistoren vom einen Kanaltyp bestehenden eigentlichen Halbleiterschaltung (ES) gebildete Serienschaltung zwischen den beiden Versorgungsanschlüssen (A, B) des Halbleiterplättchens durch jede der weiteren Kaskaden ($I_2$, $I_3$) überbrückt ist, daß außerdem jede der weiteren Kaskaden aus einem MOS-Treibertransistor ($T_2$, $T_3$) und einem als Diode geschalteten Lasttransistor (t) besteht und dabei der Sourceanschluß des Treibertransistors am Substratanschluß (1) und der Drain des Lasttransistors an dem zugleich an der eigentlichen integrierten Schaltung (ES) unmittelbar angeschlossenen Versorgungsanschluß (A) des Halbleiterplättchens und außerdem das Gate des Treibertransistors ($T_2$, $T_3$) der nachfolgenden Kaskaden ($I_2$, $I_3$) am Drain des Treibertransistors ($T_1$, $T_2$) der jeweils vorgeschalteten Kaskade ($I_1$, $I_2$) und das Gate des Treibertransistors ($T_1$) der ersten Kaskade ($I_1$) am Drain des Treibertransistors ($T_3$)

der letzten Kaskade ($I_3$) liegen, und daß schließlich die Treibertransistoren ($T_1$, $T_2$, $T_3$) und die Lasttransistoren (t) denselben Kanaltyp wie die die eigentliche Schaltung (ES) aufbauenden Feldeffekttransistoren haben.

8. Halbleiterschaltung nach den Ansprüchen 1 bis 7, d a d u r c h   g e k e n n z e i c h n e t ,   daß die aus MOS-Transistoren aufgebaute und mit dem Substratvorspannungserzeuger in Serie bezüglich der beiden Versorgungsanschlüsse (A, B) des Halbleiterkörpers eigentliche Halbleiterschaltung (ES) durch einen nach der TTL-Technik aufgebauten Schaltungsteil über einen Steuereingang (TE) gesteuert ist, daß hierzu der Steuereingang (TE) an das Gate eines an die TTL-Verhältnisse adaptierten Eingangstransistors ($T^*$) gelegt und der Sourceanschluß dieses Treibertransistors ($T^*$) an den Substratanschluß (1) sowie sein Drain über die Source-Drainstrecke eines Lasttransistors ($t_1$) mit dem an der eigentlichen Halbleiterschaltung (ES) liegenden Versorgungsanschluß (A) des Halbleiterplättchens (H) sowie am Gate eines den Eingang der eigentlichen Halbleiterschaltung (ES) bildenden und mit seinem Sourceanschluß am Ausgang (2) des Substratvorspannungserzeugers (SE) liegenden Transistors ($t_2$) liegt.

9. Halbleiterschaltung nach den Ansprüchen 1 bis 8, d a d u r c h   g e k e n n z e i c h n e t ,   daß die aus MOS-Transistoren aufgebaute und mit dem Substratvorspannungserzeuger (SE) in Serie bezüglich der beiden Versorgungsanschlüsse (A, B) des Halbleiterplättchens liegende eigentliche Halbleiterschaltung (ES) zur Steuerung eines nach der TTL-Technik aufgebauten Schaltungsteils über einen Steuerausgang (TA) vorgesehen ist, daß hierzu der Signalausgang (AU) der in Serie mit dem Substratvorspannungserzeuger (SE) liegenden eigentlichen Halbleiterschaltung zur Steuerung einer zwischen dem

Substratanschluß (1) und dem an der eigentlichen Halbleiterschaltung (ES) liegenden MOS-Inverters ($T^*$, $t_5$)
liegt, daß ferner der Ausgang dieses Inverters den
TTL-Steuerausgang (A) bildet und daß der Treibertransistor ($T^*$) dieses Inverters an die TTL-Verhältnisse adaptiert ist.

## FIG 1

$V_{CC}$ ○ (A)
$V_{SS}$ ○
$V_{BB}$ ○ (B)

is

↑ TTL-Ausgang

↑ TTL-Eingang

## FIG 2

(A) ○
(B) ○
$V_{CC}$

is

↑ TTL-Ausgang
0-2,4V

↑ TTL-Eingang
0-2,2V

## FIG 3

A ○
+
$V_{CC}$
z.B.5V
−
B ○

3

2,5V
0
2,5V

ES

SE

2 — $V_{SS}$

H

1

## FIG 4

3

+A ST
$V_{CC}$
−B

ES

2

0
+
$R_e$

R

1

## FIG 5

3

A ○
$V_{CC}$
B ○

ES

2 — $V_{SS}$

T

1

FIG 6

FIG 7

FIG 8